# EUROPÄISCHE PATENTSCHRIFT

(11) **EP 3 386 914 B1**
(45) Veröffentlichungstag und Bekanntmachung des Hinweises auf die Patenterteilung: **02.12.2020**
(21) Anmeldenummer: 16822373.3
(22) Anmeldetag: 16.11.2016
(51) Int. Cl.: C01B 32/194

(54) **VERFAHREN ZUM TRANSFER VON GRAPHEN-STÜCKEN AUF EIN SUBSTRAT**
METHOD FOR TRANSFERRING GRAPHENE PIECES ONTO A SUBSTRATE
PROCÉDÉ DE TRANSFERT DE MORCEAUX DE GRAPHÈNE SUR UN SUBSTRAT

(30) Priorität: 12.12.2015 DE 102015016143
(43) Veröffentlichungstag der Anmeldung: 17.10.2018
(73) Patentinhaber: Forschungszentrum Jülich GmbH, 52425 Jülich (DE)
(72) Erfinder: KIREEV, Dmitry, 52428 Jülich (DE); SARIK, Dario, 52068 Aachen (DE); WOLFRUM, Bernhard, 85716 Unterschleissheim (DE); OFFENHÄUSSER, Andreas, 52064 Aachen (DE)
(86) Internationale Anmeldenummer: PCT/DE2016/000400
(87) Internationale Veröffentlichungsnummer: WO 2017/097279

(56) Entgegenhaltungen:
- EP-A1- 2 937 313
- WO-A1-2015/075292
- XIANG ZHANG ET AL: "Graphene's potential in materials science and engineering", RSC ADVANCES: AN INTERNATIONAL JOURNAL TO FURTHER THE CHEMICAL SCIENCES, Bd. 4, Nr. 55, 23. Mai 2014 (2014-05-23), Seite 28987, XP055339915, GB ISSN: 2046-2069, DOI: 10.1039/C4RA02817A
- WEI-HSIANG LIN ET AL: "A Direct and Polymer-Free Method for Transferring Graphene Grown by Chemical Vapor Deposition to Any Substrate", ACS NANO, Bd. 8, Nr. 2, 25. Februar 2014 (2014-02-25), Seiten 1784-1791, XP055339735, US ISSN: 1936-0851, DOI: 10.1021/nn406170d
- JAN-KAI CHANG ET AL: "Graphene Anodes and Cathodes: Tuning the Work Function of Graphene by Nearly 2 eV with an Aqueous Intercalation Process", ACS APPLIED MATERIALS AND INTERFACES, Bd. 7, Nr. 31, 12. August 2015 (2015-08-12), Seiten 17155-17161, XP055339860, US ISSN: 1944-8244, DOI: 10.1021/acsami.5b03934
- SUK J W ET AL: "Transfer of CVD-Grown Monolayer Graphene onto Arbitrary Substrates", ACS NANO, AMERICAN CHEMICAL SOCIETY, US, Bd. 5, Nr. 9, 27. September 2011 (2011-09-27), Seiten 6916-6924, XP002720932, ISSN: 1936-0851, DOI: 10.1021/NN201207C [gefunden am 2011-09-06]

## Beschreibung

Die Erfindung bezieht sich auf ein Verfahren zum Transfer von Graphen-Stücken auf ein Substrat.

### Stand der Technik

Aus XIANG ZHANG et al. ("Graphene's potential in materials science and engineering", RSC ADVANCES: AN INTERNATIONAL JOURNAL TO FURTHER THE CHEMICAL SCIENCES, Bd. 4, Nr. 55, 23. Mai 2014 (2014-05-23), Seite 28987, XP055339915, GB, ISSN: 2046-2069, DOI: 10.1039/C4RA02817A) werden verschiedene Einsatzmöglichkeiten von Graphen in den Materialwissenschaften beschrieben.

Aus WEI-HSIANG LIN et al. (A Direct and Polymer-Free Method for Transferring Graphene Grown by Chemical Vapor Deposition to Any Substrate", ACS NANO, Bd. 8, Nr. 2, 25. Februar 2014 (2014-02-25), Seiten 1784-1791, XP055339735, US, ISSN: 1936-0851, DOI: 10.1021/nn406170d) ist eine direkte und polymerfreie Methode für den Transfer von aus chemischen Gasphasenabscheidungen gewachsenen Graphenen zu einem Substrat bekannt.

Aus EP 2 937 313 A1 ist eine Vorrichtung und ein Verfahren zum automatischen Übertragen einer Graphen-Monolage auf ein Substrat bekannt.

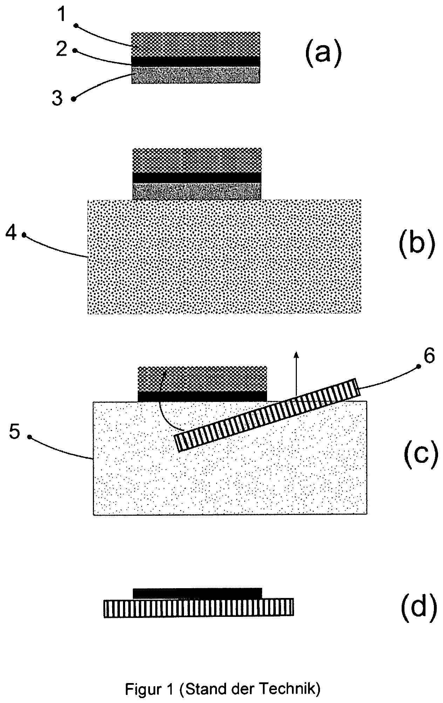

Aus Suk et al. ist ein Verfahren zum Transfer von CVD gewachsenem Graphen auf Substrate bekannt. Das Verfahren wird als Nasstransfer bezeichnet und häufig verwendet (Suk, J. W., Kitt, A., Magnuson, C. W., Hao, Y., Ahmed, S., An, J., ... Ruoff, R. S. (2011). Transfer of CVD-grown monolayer graphene onto arbitrary substrates. ACS Nano, 5(9), 6916-24.). Der Nasstransfer besteht aus den folgenden Schritten (Fig. 1 - Stand der Technik):
a) Zunächst wird Graphen 2 auf einer Kupferfolie 3 mittels der CVD-Methode gewachsen [Mattevi, C., Kim, H., & Chhowalla, M. (2011). A review of chemical vapour deposition of graphene on copper. Journal of Materials Chemistry, 21(10), 3324.
b) Das Graphen 2 auf der Kupferfolie 3 wird sodann mit einem 200-500nm dickem Film PMMA 1 rotationsbeschichtet. (Figur 1a).
c) Die Folie wird mit dem Kupfer 3 voraus in eine Kupferätzlösung 4 gegeben (Figur 1b) und wird dort solange aufbewahrt, bis sichergestellt ist, dass das Kupfer komplett aufgelöst ist. Daraufhin wird die Ätzlösung zur Reinigung des PMMA/Graphenfilms 1, 2 mit deionisiertem Wasser 5 ausgetauscht.
d) Das Zielsubstrat 6 wird als "Angel" Werkzeug benutzt um den PMMA/Graphen 1, 2 Film von der Wasseroberfläche 5 aufzusammeln (Figur 1c).
e) Das Substrat 6 wird getrocknet und das PMMA wird mit Lösungsmittel entfernt (Figur 1d). Es verbleibt das Graphen 2 auf dem Zielsubstrat 6 (Bezugszeichen nicht dargestellt).

Schichten identischer Schraffur in Figur 1a-d entsprechen einander.

Der "Angeltransfer" ist leicht für Substrate bis zu einer Ausdehnung von 1-Zoll durchzuführen. Allerdings tauchen bei Maßstäben von 4-8 Zoll Probleme auf. Nachteilig wird der "Nasstransfer" bei größeren Graphen-Stücken zunehmend schwieriger durchzuführen und es entstehen zu viele Defekte durch Falten und Risse in den transferierten Strukturen auf dem Substrat. Selbst wenn es erreicht wird, ein großes Stück Graphen im Zollmaßstab mit n-Zoll, z. B. mit n>2, auf einen n-Zoll Substrat oder Wafer zu transferieren, wird in der Regel das meiste Graphen nach dem Transfer wieder weggeätzt, was eine unökonomische Materialverschwendung ist.

Auch der präzise Transfer von mehr als 2 Stücken Graphen auf eine gewünschte Stelle auf dem Zielsubstrat ist unter Einhaltung eines genauen Abstandes zwischen den Stücken mit dem gewöhnlichen "Nasstransfer" nicht möglich. Letztlich bewegen sich während des Trocknens und des Fishings die kleinen Graphen-Stücke von der gewünschten Stelle durch die Oberflächenspannung des Wassers wieder weg.

### Aufgabe der Erfindung

Aufgabe der Erfindung ist es, ein schnelles, einfaches und ökonomisches Verfahren zum Transfer von Graphen-Stücken auf große Substrate für die weitere Fabrikation bereit zu stellen, das die Nachteile aus dem Stand der Technik nicht aufweist. Ferner ist es eine Aufgabe der Erfindung, ein Substrat mit einer Mehrzahl darauf platzierter Graphen-Stücke bereit zu stellen und weitere Verwendungen derartiger Substrate aufzuzeigen. Eine weitere Aufgabe der Erfindung ist es, eine Vorrichtung zur Durchführung des Verfahrens bereit zu stellen.

### Lösung der Aufgabe

Die Aufgabe wird gelöst mit dem Verfahren nach Patentanspruch 1 und der Vorrichtung zur Durchführung des Verfahrens sowie dem Substrat, hergestellt nach dem Verfahren gemäß der Nebenansprüche. Vorteilhafte Ausgestaltungen hierzu ergeben sich jeweils aus den hierauf rückbezogenen Patentansprüchen.

### Beschreibung der Erfindung

Das Verfahren zum Transfer von Graphen-Stücken auf ein Substrat, ist gekennzeichnet durch die Schritte:
a) Es wird ein Substrat, insbesondere geeignet für die Halbleiter-Industrie, mit einer Mehrzahl an Platzhaltern für die Graphen-Stücke ausgewählt;
b) Das Substrat wird auf einem Substrathalter in einer Kammer angeordnet und ausgerichtet;
c) Es wird eine Transferschicht mit Öffnungen als Platzhalter für die Graphen-Stücke ausgewählt;
d) Die Transferschicht wird auf dem Substrathalter über dem Substrat angeordnet und ausgerichtet, sodass die Öffnungen in der Transferschicht über den Platzhaltern auf dem Substrat ausgerichtet werden. Vorzugsweise wird dabei die Transferschicht in der X-Y-Ebene fixiert;
e) Es wird eine Flüssigkeit in die Kammer bis oberhalb der Transferschicht eingefüllt, und die Transferschicht auf der Flüssigkeitssäule angehoben;
f) Es werden Graphen-Stücke auf den Flüssigkeitsfilm in die Öffnungen der Transferschicht eingebracht;
g) Der Abstand zwischen dem Substrat und den Graphen-Stücken wird verringert, bis die Graphen-Stücke auf den Platzhaltern des Substrats angeordnet werden.

Hierzu kann die Flüssigkeit aus der Kammer entnommen werden, so dass die Transferschicht auf der Flüssigkeitssäule abgesenkt wird und die Graphen-Stücke in den Öffnungen der Transferschicht auf die Platzhalter des Substrats transferiert werden.

Alternativ ist es in Schritt g) auch möglich, das Substrat durch einen langsamen Hebemechanismus zu den schwimmenden Graphen-Flocken zu bewegen. Dazu soll die Transferfolie in der Z-Ebene fixiert sein und ein Hebemechanismus für das Substrat in der Kammer angeordnet sein.

Dadurch wird vorteilhaft bewirkt, dass die Methode eine Relativbewegung zur Verringerung des Abstands zwischen der Substrat-Oberfläche und der Flüssigkeits-Oberfläche umfasst.

Durch die Erfindung wird Graphen präzise an die gewünschten Stellen des Substrats, den Platzhaltern, transferiert. Dies wird erreicht, indem das Substrat mit einem Muster versehen wird, um die gewünschten Regionen, an denen Graphen platziert werden soll, zu definieren. Die gewünschten Stellen bzw. Regionen auf dem Substrat werden im Weiteren auch als Platzhalter bezeichnet.

Das Graphen wird also erfindungsgemäß anstatt auf das gesamte Substrat nur auf diese kleinen Regionen, den Platzhaltern auf dem Substrat transferiert. Dieses Muster kann flexibel nach dem jeweiligen Anwendungszweck für das Substrat gewählt werden.

Das Verfahren erlaubt vorteilhaft einen halbautomatischen Transfer von Graphen-Stücken auf die gewünschten Stellen auf einen Wafer. Das Verfahren hat im Vergleich zu konventionellen Graphen-Transferverfahren eine bis zu 2500% höhere Ausbeute.

Mit der Lösung der Erfindung werden Graphen-Stücke genau auf die gewünschten Regionen transferiert. N_g sei hierbei die Anzahl der gewünschten Regionen auf dem Zielsubstrat mit der spezifischen Flächenausdehnung A. Die erfindungsgemäße Lösung der Aufgabe minimiert die Menge an verschwendetem Material, und vereinfacht und beschleunigt weiterhin den Prozess für großskalige Transferprozesse.

Das erfindungsgemäße Verfahren stellt somit einen Zwischenschritt zur großangelegten Produktion von Graphen-basierten Bauelementen auf industriellem Maßstab dar.

Das Verfahren im Detail sieht folgende Schritte vor.

### Schritt a):

Im ersten Schritt erfolgt die Auswahl des Substrats mit Platzhaltern. Dadurch wird der Fabrikationsablauf und das Substrat für ein gewünschtes Bauelement bzw. Bauelemente bestimmt. Danach entscheidet sich, wie viel Graphen insgesamt für das Substrat notwendig ist, sowie die Anzahl der Graphen-Stücke. N_g stellt dabei die durch die Platzhalter auf dem Substrat erhaltene Zahl an gewünschten Stellen dar, auf denen das Graphen angeordnet werden soll. A bezeichnet dabei die durch ein einzelnes Graphen-Stück abgedeckte Fläche. Für gewöhnlich ist die gesamte Fläche, die vom Graphen auf dem Substrat abgedeckt wird, durch A*N_g definiert und beträgt vorteilhaft im Sinne der Erfindung in der Regel unter 10%, vorzugsweise weniger als 9%, 8%, 7%, 6% oder sogar weniger als 5% der Gesamtfläche des Substrats.

Jedes beliebige Substrat, insbesondere Substrate aus der Halbleiter-Technologie kann hierzu ausgewählt werden, das heißt insbesondere Silizium-Wafer. Die Platzhalter auf dem Wafer können durch Chips in erster Näherung definiert werden, auf denen die Graphen-Stücke platziert werden sollen. In den Chips sind die eigentlichen Platzhalter angeordnet. Die Fläche eines Platzhalters entspricht vorteilhaft etwa der Fläche eines zu transferierenden Graphen-Stückes.

### Schritt b):

Im zweiten Schritt wird das Substrat auf einem Substrathalter in einer Kammer angeordnet und ausgerichtet.

Die Kammer ist eine Vorrichtung zur Durchführung des Verfahrens.

Die erfindungsgemäße Vorrichtung zur Durchführung des Verfahrens umfasst hierzu mindestens eine Hauptkammer, vorzugsweise mit einer Vakuumansaugvorrichtung im Substrathalter für das Substrat, einer Anzahl von N_c Fixierstiften bzw. Alignmentsäulen, mit N=Anzahl und c=columns. Die Kammer weist vorteilhaft auch einen Zufluss und/oder einen Abfluss für eine Flüssigkeit auf.

Der Begriff Fixierstift wird im Weiteren synonym zu Allignmentsäule angewendet.

Die Kammer umfasst einen Substrathalter, mit einer Fläche abhängig von den Dimensionen des Substrats und geeignet zur Platzierung des Substrats auf dem Substrathalter. Der Substrathalter ist im Boden der Kammer angeordnet und vorzugsweise mit einer Vorrichtung zum Anlegen des Vakuums ausgestattet.

Das Substrat wird auf dem Substrat-Halter mit den Platzhaltern nach oben angeordnet und ausgerichtet. Der Substrathalter ist Bestandteil der Kammer und befindet sich entsprechend im Innern der Kammer. Der Substrathalter ist auf einer Bodenplatte der Kammer angeordnet, z. B. damit verschraubt. Der Substrathalter und gegebenenfalls weitere vorgesehene Mittel fixieren das Substrat an seiner vorgesehen Stelle.

Die Ausrichtung des Substrats erfolgt in der Weise auf dem Substrathalter, dass ein Verrutschen des Substrats auf dem Halter während der Durchführung des Verfahrens ausgeschlossen ist. Zu diesem Zweck kann ein Vakuumhalter als Substrathalter verwendet werden. Nach dem Platzieren und Ausrichten des Substrats auf dem Halter wird das Substrat vorteilhaft durch ein Vakuum auf dem Substrathalter fixiert.

In einer vorteilhaften Ausgestaltung der Erfindung weist die Vorrichtung zu diesem Zweck weitere Mittel zur Ausrichtung und Fixierung des Substrats und/oder weiterer Schichten wie der Transferschicht auf dem Substrat auf.

Als Mittel kann insbesondere mindestens ein senkrecht im Boden der Kammer oder auf dem Rand des Substrathalters verankerter Fixierstift angeordnet sein, der das Substrat begrenzt. Mehrere Fixierstifte können auf oder um den Rand des Substrathalters herum im Boden der Kammer angeordnet sein. Der oder die Fixierstifte sind senkrecht in der Kammer aufgerichtet und als Alignmentmarker angeordnet, mit denen das Substrat und/oder insbesondere weitere Schichten, wie eine Transferschicht in der X-Y-Richtung fixiert werden, so dass eine Rotation der Transferschicht ausgeschlossen wird.

Der oder die Fixierstifte können auch in einem gewissen Abstand um den Substrat-halter herum entfernt angeordnet sein und diesen umgeben.

Der oder die Fixierstifte können in der Bodenplatte der Kammer verankert, z. B. verschraubt sein.

Der oder die Fixierstifte können auch auf dem Rand des Substrathalters verankert, z. B. verschraubt sein.

Die Abmessungen der Kammer, der Abstand der Fixierstifte zueinander und zum Substrat bzw. zum Substrathalter und so weiter hängen von den Abmessungen des Substrats selbst sowie dem Durchmesser des Substrathalters ab.

Es können insbesondere eine Vielzahl, z. B. 3, 4, 5, oder insbesondere 6 oder mehr Fixierstifte in der Kammer angeordnet sein, die das Substrat bzw. eine Transferschicht an seinen Außenrändern begrenzen und/oder das Verrutschen des Substrats bzw. einer Transferschicht auf dem Substrathalter verhindern.

Zu diesem Zweck sind eine Vielzahl an Fixierstiften entlang des äußeren Randes des Substrats und insbesondere in der Bodenplatte der Kammer angeordnet. Der oder die Fixierstifte verhindern das Ausbrechen des Substrats bzw. einer Transferschicht in der X-Y-Ebene von seiner auf dem Halter vorgesehenen Platz.

In einer weiteren ganz besonders vorteilhaften Ausgestaltung der Erfindung verhindern der oder die Fixierstifte als Mittel die Rotation des Substrats und weiterer Schichten auf dem Substrat angeordneten Schichten, wie insbesondere der Transferschicht, mit der die Graphen-Stücke auf den Platzhaltern des Substrats angeordnet werden sollen.

Die Mittel verhindern dabei bei der Durchführung des Verfahrens die Rotation insbesondere dieser Transferschicht um ihren Mittelpunkt herum. Die Transferschicht wird dabei durch das oder die Mittel, wie den Fixierstiften, in ihrer X-Y-Ebene fixiert. Die Transferschicht selbst lässt sich gleichzeitig in der der Z-Ebene bewegen. Das Substrat verbleibt dabei fixiert auf dem Substrathalter.

Die Mittel bewirken auf diese Weise vorteilhaft, dass während der Durchführung des Verfahrens die Öffnungen in der Transferschicht zur Aufnahme des Graphen exakt über den Platzhaltern im Substrat angeordnet bleiben.

Das auf dem Halter fixierte Substrat ist auf diese Weise für den Transfer der Graphen-Stücke vorbereitet.

### Schritt c):

Die für das Verfahren wichtige Transferschicht wird ausgewählt bzw. hergestellt. Dabei wird die Transferschicht hergestellt, in dem das Muster, das heißt die Position, die Anzahl und die Größe der Platzhalter des Substrats maßstabsgetreu auf die Transferschicht übertragen wird und Öffnungen entsprechend dieses Musters in der Transferschicht hergestellt werden. Diese Öffnungen werden im Weiteren verwendet um die Graphen-Stücke darin einzubringen und auf die Platzhalter des Substrats aufzubringen.

Die Transferschicht weist somit vorzugsweise Öffnungen mit einer Position, Größe und Anzahl auf, die der Position, Anzahl und Größe der Platzhalter auf dem Substrat entsprechen. Die Öffnungen in der Transferschicht sind exakt auf den Platzhaltern des Substrats angeordnet und für die Aufnahme der Graphen-Stücke vorgesehen. Die Öffnungen weisen dasselbe Muster auf, wie die Platzhalter im Substrat, sind also im selben Abstand zueinander angeordnet, wie die Platzhalter auf dem Substrat.

Die Transferschicht kann darüber hinaus weitere Öffnungen zur Fixierung in X-Y-Richtung an den Fixierstiften der Kammer aufweisen.

Die Transferschicht ist vorzugsweise ein dünner flexibler Film, z. B. ein Polymerfilm, ein Film aus Kapton oder aus einem anderen Material.

Die Transferschicht kann aus einem Kunststoff z. B. einem Polyimid bestehen, z. B. aus Polysuccinimid, Polybismaleinimid, Polybenzimidazol und Polyoxadiazobenzimidazol, Polyimidsulfon oder Polymethacrylimid.

Die Transferschicht hat die Funktion eines Vermittlers für den Graphen-Transfer auf das Substrat und wird daher als Transferschicht oder Vermittlerschicht bezeichnet.

Die Transferschicht kann insbesondere aus hydrophobem Material bestehen. Dadurch wird vorteilhaft bewirkt, dass der Film eine abstoßende Wirkung auf hydrophile Flüssigkeiten wie z. B. Wasser aufweist. Auf diese Weise wird vorteilhaft bewirkt, dass der Film bei Kontakt mit wässrigen Flüssigkeiten auf dieser schwimmt.

Die Transferschicht kann vorzugsweise aus einem transparenten oder zumindest halb-transparenten Material bestehen. Dadurch wird vorteilhaft bewirkt, dass ein Abgleich, das heißt ein auf Deckung bringen der Öffnungen im Film exakt über den Platzhaltern des Substrats ermöglicht wird.

Das Muster der Platzhalter auf dem Substrat wird maßstabsgetreu auf die Transferschicht übertragen, beispielweise durch ein Druckverfahren.

Die Transferschicht weist darüber hinaus vorzugsweise gegenüberliegende Ausnehmungen auf, mit denen sie an den Fixierstiften in ihrer X-Y-Ebene, nicht jedoch in ihrer Z-Ebene über dem Substrat, fixiert wird.

Die Transferschicht hat hierzu etwas größere Abmessungen als das Substrat.

### Schritt d):

Im nächsten Schritt wird diese Transferschicht auf dem Substrathalter über dem Substrat angeordnet und ausgerichtet, sodass die Öffnungen der Transferschicht für die Graphen-Stücke exakt über den Platzhaltern auf dem Substrat ausgerichtet werden.

Die Öffnungen in der Transferschicht werden hierzu mit den Platzhaltern auf dem Substrat zur Deckung gebracht. Wenn die Transferschicht auf dem Substrat korrekt angeordnet und ausgerichtet ist, liegen die Öffnungen der Transferschicht über den Platzhaltern des Substrats.

Die Transferschicht stellt im erfindungsgemäßen Sinne also eine Maske für das Substrat dar. Die Platzhalter des Substrats werden auf Grund der Öffnungen in der Transferschicht nicht maskiert, da die Öffnungen der Transferschicht direkt über den Platzhaltern angeordnet werden. Außerhalb der Platzhalter hingegen wird das Substrat durch die Transferschicht maskiert.

Die Maskierung bewirkt vorteilhaft, dass ein Transfer der Graphen-Stücke über die Öffnungen der Transferschicht nur auf die dafür vorgesehenen Stellen des Substrats, also auf die Platzhalter in den Chips erfolgen kann, da die übrigen Stellen des Substrats maskiert sind.

Diese Ausrichtung der Transferschicht mit den Öffnungen auf den Platzhaltern des Substrats wird vorzugsweise durch die in der Vorrichtung angeordneten Mittel zur Fixierung des Substrats und/oder der Transferschicht während des Verfahrens in der X-Y-Ebene nicht mehr verändert. In anderen Worten: Die Transferschicht ist auf dem Substrat derartig durch Mittel zur Fixierung, z. B. den Fixierstiften fixiert, so dass die Öffnungen in der Transferschicht immer über den Platzhaltern zu liegen kommen. Die Mittel zur Anordnung und Ausrichtung der Transferschicht, die Fixierstifte, erlauben dabei eine Fixierung der Transferschicht in der X-Y-Ebene, das heißt in der Ebene der größten Ausdehnung der Transferschicht und verhindern deren Rotation um den Mittelpunkt. In der Z-Ebene ist die Transferschicht hingegen frei beweglich, da der Durchmesser der Ausnehmungen, mit denen die Transferschicht an dem oder den Fixierstiften befestigt wird, etwas größer ist, als der Durchmesser der Fixierstifte.

Dadurch wird vorteilhaft bewirkt, dass die Transferschicht vom Substrat abgehoben werden kann, ohne die Funktion als Maske grundsätzlich zu verlieren, und ohne dass eine Nachjustage der Öffnungen nach dem erneuten Herablassen der Transferschicht notwendig ist. Die Transferschicht ist somit in der Z-Ebene der Kammer, nicht aber oder zumindest unwesentlich, in der X-Y-Ebene beweglich und sie kann senkrecht zum Substrat durch Flüssigkeit angehoben und herabgelassen werden, ohne dass eine Nachjustage der Öffnungen in der Transferschicht über den Platzhaltern des Substrats notwendig ist. Das Substrat bleibt dabei auf dem Substrathalter fixiert.

In Aufsicht auf die Transferschicht und das Substrat ist während der Durchführung des gesamten Verfahrens auf diese Weise vorteilhaft sichergestellt, dass die Öffnungen in der Transferschicht immer exakt oberhalb der Platzhalter auf dem Substrat angeordnet sind.

Die Transferschicht hat vorzugsweise in erster Näherung eine Form, wie das Substrat, da sie dieses maskieren soll. Die Transferschicht kann z. B. für einen Wafer als Substrat im Wesentlichen ebenfalls rund sein.

Über die Fläche des Substrats hinausreichend weist die Transferschicht aber z. B. ohrenförmige, halbkreisförmige Ausstülpungen auf. Diese Ausstülpungen weisen vorzugsweise die genannten Ausnehmungen in der Mitte der Ausstülpungen zur Fixierung auf.

Diese Maßnahme bewirkt vorteilhaft, dass die Transferschicht mit den Ausnehmungen an die in der Kammer angeordneten Fixierstifte befestigt werden kann. Insbesondere ist in jeder der Ausstülpungen der Transferschicht entsprechend eine durch den Film hindurchführende Ausnehmung angeordnet. Die Ausnehmungen weisen vorteilhaft einen etwas größeren Durchmesser auf als der Durchmesser der Fixierstifte, so dass die Ausnehmungen der Transferschicht über die Fixierstifte gestreift werden können und die Transferschicht in der X-Y-Ebene fixiert wird nicht hingegen jedoch in Z-Ebene. Dabei sind die Durchmesser der Ausnehmungen und der Fixierstifte so aufeinander abzustimmen, dass die Transferschicht durch den Einlass einer Flüssigkeit in die Kammer an den Fixierstiften fixiert, angehoben werden kann.

Diese Maßnahme bewirkt zudem vorteilhaft, dass die Transferschicht vom Substrat in der Z-Ebene der Kammer durch Einlassen und Ablassen der Flüssigkeit angehoben und wieder herabgelassen werden kann und die Öffnungen für die Graphen-Stücke in der Transferschicht wieder exakt auf den Platzhaltern des Substrats zu liegen kommen. Transfermedium ist hierbei der steigende und/oder sinkende Flüssigkeitspegel, auf dem die Graphen-Stücke schwimmen.

Die Transferschicht wird entsprechend so gewählt und ausgestaltet, dass sie mit ihren Ausstülpungen einen Überlapp über das Substrat hinaus bis an den oder die Fixierstifte aufweist.

Die Transferschicht kann an den oder die Fixierstifte befestigt werden, z. B. durch Clippen oder Überstülpen der Ausnehmungen über die Fixierstifte zur Fixierung der Position der Öffnungen über den Platzhaltern des Substrats.

Wenn mehr als ein Fixierstift im Kammerboden bzw. um oder auf dem Substrathalter zur Begrenzung des Substrats angeordnet sind, so weist die Transferschicht vorzugsweise eine Fläche und Ausstülpungen für alle diese Fixierstifte auf. Die Transferschicht weist hierzu neben den Öffnungen für die Graphen-Stücke Ausstülpungen mit Ausnehmungen für die Fixierstifte auf, um diese an den Fixierstiften zu befestigen, beispielweise um die Ausnehmungen über die Fixierstifte zu führen und auf diese Weise auch eine Rotation der schwimmenden Transferschicht um ihren Mittelpunkt zu verhindern.

Vorzugsweise sollte die Kammer zur Durchführung des Verfahrens mindestens 2, besser 3, 4, 5, oder vorzugsweise 6 oder noch mehr Fixierstifte aufweisen, die so angeordnet sind, dass sie den Substrathalter begrenzen bzw. umgeben. Die Länge der Fixierstifte ist im Wesentlichen durch die Höhe der Kammer vorgegeben.

Die Oberkante der Fixierstifte ist im Querschnitt auf die Kammer betrachtet, jedenfalls einige Zentimeter oberhalb der Oberfläche des Substrathalters und des darauf liegenden Substrats angeordnet. Die Fixierstifte können auch auf dem Substrathalter selbst angeordnet sein, sofern das Substrat kleiner als der Substrathalter gewählt wird und die Fixierstifte das Substrat an seinen Außenrändern etwa begrenzen.

Der Substrathalter weist vorteilhaft eine etwa identische Fläche zum Substrat auf. Die Fläche des Substrathalters kann in einer Ausgestaltung der Erfindung derartig groß sein, dass die in der Halbleiter-Industrie gängigen Wafer auf dem Substrathalter darauf platziert werden können.

Kammer und Substrathalter, Fixierstifte und dergleichen bestehen vorzugsweise aus einem Kunststoff, wie z. B. Polymethylmethacrylat.

Vorzugsweise ist der Substrathalter nicht mit der Kammer fest verbunden, sondern kann ausgetauscht werden, so dass verschiedene Substrathalter für unterschiedliche Substratgrößen in die Kammer eingesetzt werden können. Hierzu kann die Kammer im Boden ein Innengewinde für ein Außengewinde eines Substrathalters aufweisen.

Die Transferschicht weist eine Gruppe an Öffnungen N_g mit der Größe A, gerade groß genug für die Graphen-Stücke auf, mit N=Anzahl, g=Graphen und A=Fläche. Diese Öffnungen sind zu unterscheiden von den Ausnehmungen für die Fixierstifte als Mittel.

Die Transferschicht weist vorzugsweise Markierungs- und Begrenzungslinien für die Chips auf, um die Ausrichtung auf dem Substrat in der gewünschten Weise vorzunehmen. Die Linien können wie die Chips auf dem Substrat ein schachbrettartiges Muster ausbilden.

Sollen beispielweise auf dem Substrat 15 Graphen-Stücke auf den Platzhaltern angeordnet werden, so weist das Substrat hierzu 15 Platzhalter auf. Die Transferschicht weist entsprechend ebenfalls mindestens 15 Öffnungen für diese Platzhalter auf. Es versteht sich, dass eine Transferschicht gewählt werden kann, die auch mehr als 15 Öffnungen für die Graphen-Stücke aufweisen kann.

Alle Öffnungen in der Transferschicht können in diese hineingeschnitten werden, z. B. durch Stanzen. Durch den Schritt der maßstabsgetreuen Überführung der Platzhalter auf dem Substrat, insbesondere des maßstabgetreuen Druckens der Platzhalter auf die Transferschicht wird vorteilhaft bewirkt, dass die Öffnungen der Transferschicht für das Graphen exakt über den Platzhaltern des Substrats ausgerichtet werden können.

### Schritt e):

Sodann wird eine Flüssigkeit in die Kammer bis oberhalb der Transferschicht auf dem Substrat eingefüllt, und die Transferschicht auf der Flüssigkeitssäule angehoben. Da die Transferschicht über die Ausnehmungen in den Ausstülpungen über die Fixierstifte hinweg nur in der Z-Richtung beweglich ist, bleiben auch die Öffnungen in der Transferschicht exakt oberhalb der Platzhalter des Substrats angeordnet. Die Transferschicht schwimmt auf der Oberfläche der Flüssigkeit.

Wenn die Endposition in Z-Ebene für die Transferschicht erreicht ist, wird der Flüssigkeitszufluss gestoppt. Sodann erfolgt der Transfer der Graphen-Stücke in die Öffnungen N_g der Transferschicht. Der Transfer kann von Hand erfolgen, da die Öffnungen in der Transferschicht in der Regel gerade groß genug sind ein Graphen-Stück aufzunehmen. Senkrecht und in Aufsicht auf die Graphen-Stücke betrachtet, liegen diese dann direkt oberhalb der Platzhalter im Substrat, und sind lediglich durch die Flüssigkeitssäule von diesen getrennt.

Vorbereitend werden beispielhaft PMMA/Graphen-Stücke wie folgt hergestellt. Eine durch CVD mit Graphen bewachsene Kupferfolie, mit einer Fläche von A*N_g, wird mit einer dünnen Schicht von z. B. >100 nm PMMA rotationsbeschichtet. Dabei wird das Polymer auf die Graphenseite aufgebracht. Das Polymer wird dann zum Aushärten ausgeheizt. Mit einem Skalpell oder einem anderem scharfen Gegenstand wird die PMMA Schicht angeritzt, um N_g Stücke mit der Fläche A herzustellen. Die PMMA/Graphen/Kupferfolie wird sodann mit dem Kupfer voran in die Kupferätzlösung gelegt. Nachdem sich das Kupfer gelöst hat werden die Stücke in deionisiertes Wasser zum Reinigen gegeben. Es versteht sich, dass auch ein anderes Metall oder Kunststoff gewählt werden kann.

### Schritt f):

Die vorbereiteten PMMA/Graphen-Stücke N_g werden sodann z. B. einzeln auf die Flüssigkeits-Oberfläche und in die Öffnungen der Transferschicht überführt. Hierzu werden die vorbereiten PMMA/Graphen-Stücke mit der Graphen-Seite nach unten z. B. von Hand oder durch ein geeignetes mechanisches Transportsystem in die dafür vorgesehenen Öffnungen der Transferschicht überführt. Beispielweise kann vorteilhaft auch ein automatisches Robotersystem angewendet werden, das die einzelnen Graphen-Stücke erkennt, aufnimmt und in die dafür vorgesehen Öffnungen der Transferschicht überführt.

### Schritt g):

Der Abstand zwischen Substrat und Graphen-Stücke auf der Flüssigkeits-Oberfläche wird solange verringert, bis die Graphen-Stücke auf den Platzhaltern des Substrats angeordnet vorliegen.

Schritt g) wird vorzugsweise angewendet, indem die Flüssigkeit aus der Kammer abgelassen wird. Alternativ ist es für eine zweite Variante denkbar, das Substrat bzw. den Substrathalter an die Flüssigkeits-Oberfläche anzuheben. Hierzu ist ein Hebemechanismus für den Substrathalter vorgesehen.

Das Wasser wird in der ersten Variante langsam abgelassen. Sollte kein Ablass in der Kammer angeordnet sein, so kann das Wasser auf jede nicht die Positionierung der Graphen-Stücke ändernde Weise entnommen werden. Es kann im einfachsten Falle die Flüssigkeit auch durch Ansaugen und Ablassen der Flüssigkeit der Kammer wieder entnommen werden.

Durch den sinkenden Flüssigkeitsspiegel fällt die Transferschicht bis die PMMA/Graphen-Stücke in Kontakt mit den Platzhaltern auf dem Substrat treten.

Das Substrat wird dann vorzugsweise über Nacht getrocknet und die Transferschicht wird vom Substrat abgenommen.

Damit ist das Verfahren grundsätzlich abgeschlossen.

Optional kann das Substrat aufgeheizt werden um die Adhäsion zwischen den Stücken und dem Substrat zu verbessern.

Für die weitere Verarbeitung wird das PMMA auf den Graphen-Stücken z. B. mit Aceton entfernt.

Im Übrigen werden vorzugsweise Masken für die Photolithographie auf dem Substrat hergestellt und verwendet, welche die weitere Prozessierung der Graphen-Stücke auf dem Substrat erlauben. Diese Masken werden im Nachgang zum erfindungsgemäßen Verfahren benötigt, um die einzelnen Schritte der Fabrikation auf einander abzugleichen. Beispielsweise muss eine erste Maske für die Transferschicht mit einer zweiten Maske für die Strukturierung des Graphens mit einer dritten Maske für die Metallisierung und mit gegebenenfalls weiteren Masken für alle folgenden Schritte abgeglichen sein.

Das Verfahren stellt somit insbesondere eine Hochdurchsatz-Transfertechnik und einen großskaligen Transfer von Graphen für elektronische Anwendungen dar. Das Verfahren kann ohne Weiteres im Wafermaßstab angewendet werden um Graphenbasierende Bauelemente, wie G-Fets herzustellen.

Damit wird vorteilhaft die Produktionsrate von Graphen-basierenden Bauelementen heraufgesetzt. Das Heraufsetzen bedeutet insbesondere die Fabrikation von Bauelementen auf einem Maßstab von mindestens 4-Zoll Wafern.

Der Graphen Transfer nach diesem Verfahren kann z. B. an SiO₂/Si Wafer, Al₂O₃ Wafer und flexible Filme wie z. B. einem Polyimidfilm als Substrat durchgeführt werden.

Das Verfahren liefert hervorragende Ausbeuten. Der Mittelwert der Ausbeute liegt bei etwa 80%, das heißt 80% aller Graphen-Stücke wurden an die richtige Stelle auf das Substrat platziert. Aus den Ergebnissen kann ferner abgeleitet werden, dass die mittlere Ausbeute des erfindungsgemäßen Verfahrens bei mindestens 80% liegt. Dies ist ein sehr hoher Wert, besonders wenn man davon ausgeht, dass im Vergleich zum Stand der Technik nur etwa 5% des Graphen benötigt wird, welches üblicherweise für diesen Wafer genutzt werden würde.

Das Verfahren ist daher sehr hilfreich um die Menge an verschwendeten Graphen zu reduzieren. Es vereinfacht den Fabrikationsprozess und kann ein Zwischenschritt zur großangelegten Produktion von Graphen-Bauelementen in industriellem Maßstab sein.

Im erweiterten Sinne stellt das erfindungsgemäße Verfahren zudem eine Hochdurchsatz-Transfertechnik und einen großskaligen Transfer von 2-dimensionalen Material auf ein Substrat dar. Es ist also im Rahmen der Erfindung denkbar, ein anderes Material als die genannten Graphen-Stücke auf ein Substrat mit dem Verfahren anzuordnen und insbesondere für elektronische Anwendungen zu prozessieren. Insbesondere sind hiermit CVD gewachsene 2-dimensionale Materialien auf HalbleiterSubstrate umfasst.

### Ausführungsbeispiele:

Im Weiteren wird die Erfindung an Hand von Ausführungsbeispielen und der beigefügten Figuren näher erläutert, ohne dass es hierdurch zu einer Beschränkung der Erfindung kommen soll.

Es zeigen:
- Figur 1: Stand der Technik
- Figur 2: Substrat mit einem großen Graphen-Stück nach Stand der Technik (a)) und mit 52 Platzhaltern (gepunktet) für 52 kleine Graphen-Stücke im Sinne der Erfindung.
- Figur 3: Transferschicht 31 mit insgesamt 44 Öffnungen 33 zur Aufnahme der Graphen-Stücke.
- Figur 4: Erfindungsgemäße Vorrichtung 40 zur Durchführung des Verfahrens.
- Figur 5: Kupfer-Graphen Folie, liniert, mit insgesamt 64 noch zusammenhängenden Graphen-Stücken.
- Figur 6: Darstellung des Substrats mit zunehmender Vergrößerung einzelner Ausschnitte von a) bis e).
- Figur 7: Ertrag des erfindungsgemäßen Verfahrens.

Figur 1 zeigt das Verfahren gemäß des Standes der Technik, wie in der Beschreibungseinleitung zu dieser Patentanmeldung dargestellt.

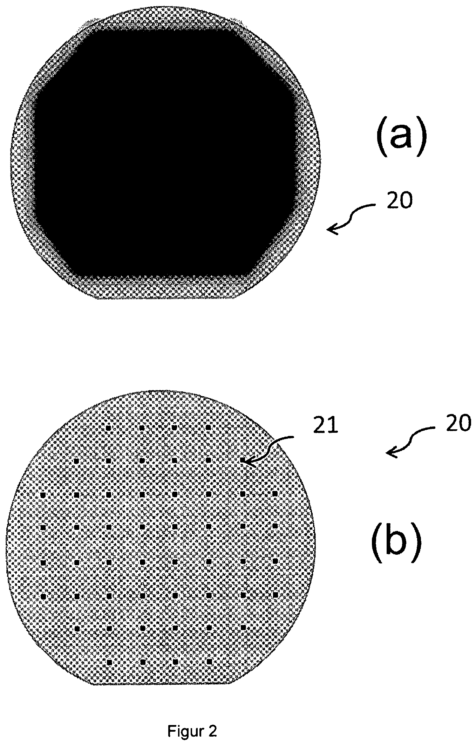

Figur 2 zeigt in der Figur a) die vollständige Belegung des Substrats mit Graphen, die nachteilig nicht faltenfrei gelingt und im Übrigen einen nur geringen Ertrag liefert, da ein erheblicher Anteil des dunkel dargestellten Graphen-Stücks wieder weggeätzt werden muss.

Figur 2 zeigt in der Figur b) den erfindungsgemäßen Ansatz einer Belegung des Substrats mit hier insgesamt bis zu 52 Graphen-Stücken. Die nicht weiter bezeichneten dunklen Punkte 21 sind die Platzhalter für die Graphen-Stücke. Vorliegend ist ein Wafer mit 10 cm Durchmesser dargestellt.

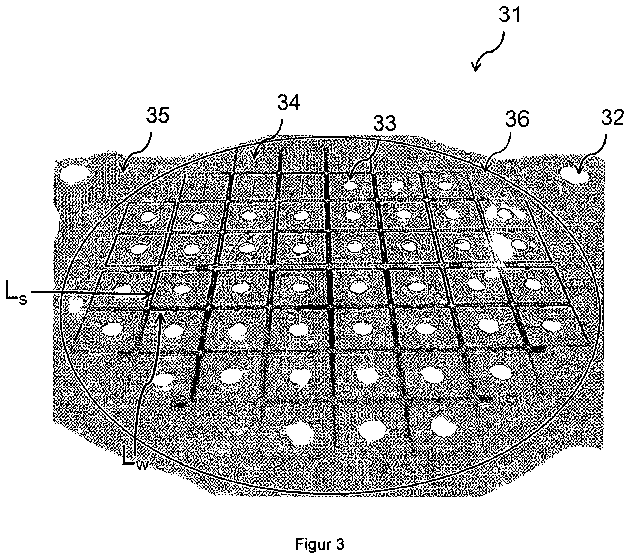

Figur 3 zeigt die Transferschicht 31. Im Nachfolgenden wurde aus Gründen der Übersichtlichkeit jeweils nur ein Mitglied von mehreren identischen Mitgliedern in der Transferschicht mit Bezugszeichen versehen.

Die Transferschicht besteht aus Kapton und weist insgesamt 44 Öffnungen 33 für die Graphen-Stücke auf. Für den vorliegenden Fall wurde eine Transferschicht gewählt, die 0,1 mm Dicke aufweist. Der Durchmesser 36 betrug 10 cm. Jede Öffnung 33 für ein Graphen-Stück hat bei 3 mm Durchmesser eine Fläche von etwa 7 mm².

Die Transferschicht weist am oberen linken und oberen rechten Rand je eine Ausstülpung 35 auf, in deren Mitte eine Ausnehmung 32 vorhanden sind. Insgesamt sind auf Grund des Schnitts an den Rändern weitere 4 der insgesamt 6 vorhandenen Ausstülpungen 35 nicht dargestellt. Jede Ausstülpung 35 weist eine Ausnehmung 32 im Zentrum auf, die groß genug ist, um sie bequem über die Fixierstifte 44 zu führen und in Z-Richtung der Kammer eine Bewegung der Transferschicht zu erlauben. Die Ausnehmungen 32 in den Ausstülpungen 35 weisen hierzu einen Durchmesser von etwa 5,25 mm auf.

Darüber hinaus weist die Transferschicht im oberen Teil 6 weitere quadratische Markierungen 34 auf, in welche jeweils eine weitere Öffnung hineingeschnitten werden könnte. Es ist darüber hinaus Platz für zwei weitere Öffnungen im linken unteren Teil der Transferschicht, so dass insgesamt 52 Öffnungen 33 in die Transferschicht eingebracht werden könnten, die den 52 Platzhaltern auf den 52 Chips entsprechen.

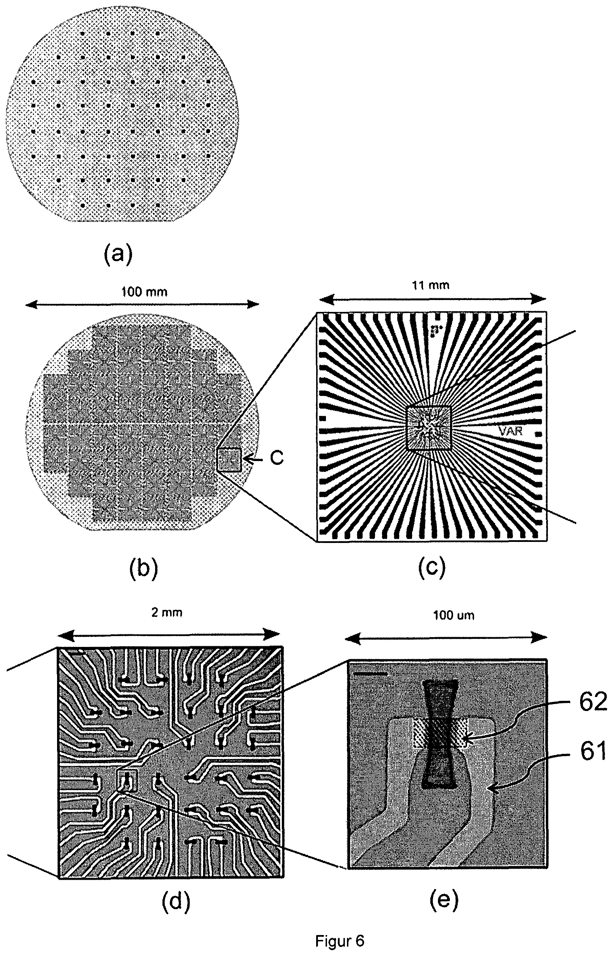

Die Transferschicht weist Markierungslinien Lₛ in senkrechter und L_{w} in waagerechter Anordnung auf, die dasselbe schachbrettartige Muster ausbilden, wie die Chips in der Figur 6b).

Die durch den Rand 36 der Transferschicht begrenzte Fläche ist etwa identisch zum Substrat. Der Rest ist Überlapp zur Fixierung an den Fixierstiften der Kammer.

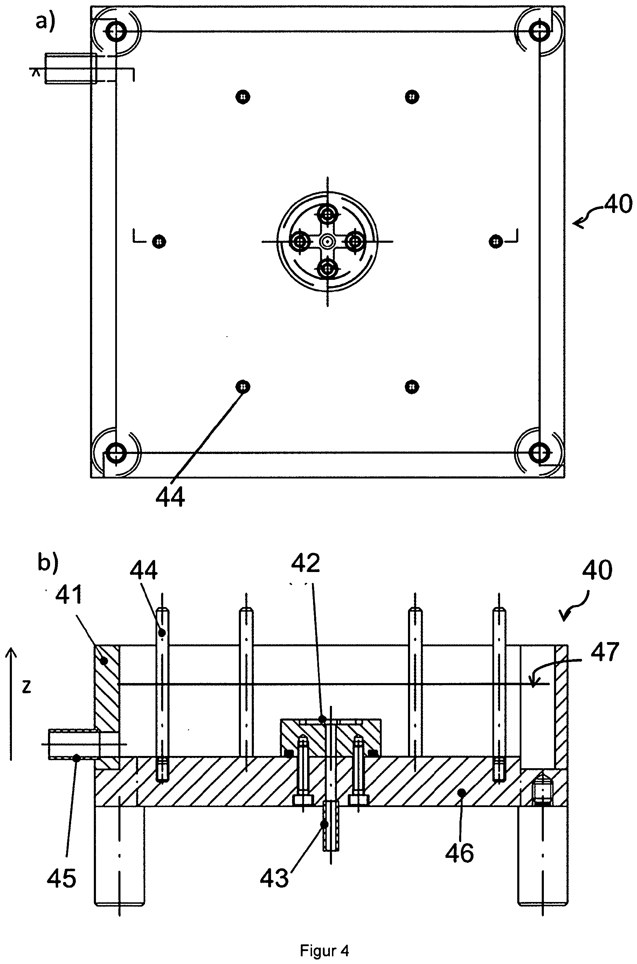

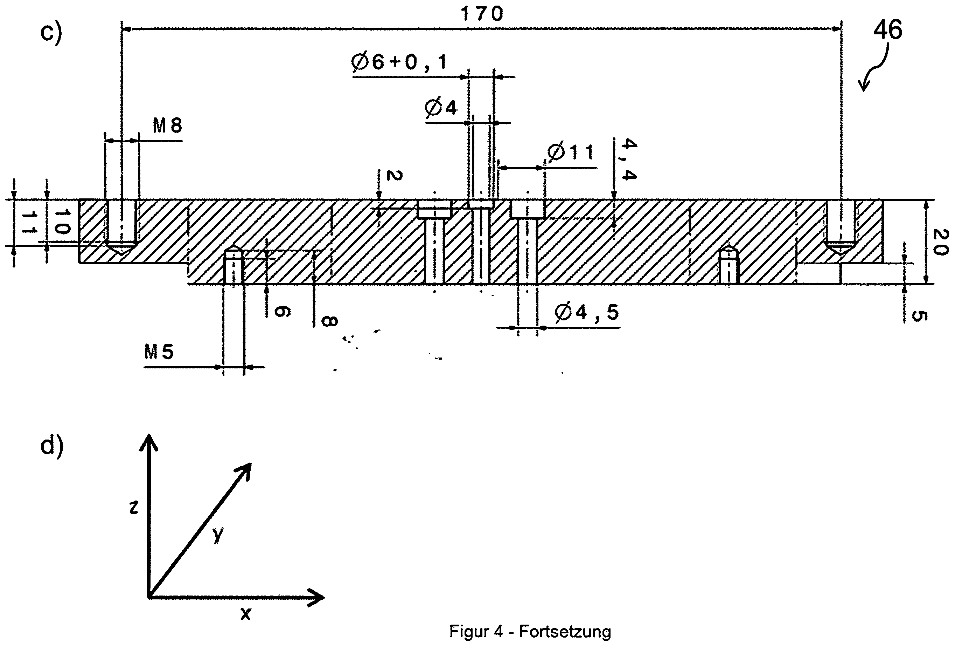

Figur 4 zeigt eine erfindungsgemäße Vorrichtung zur Durchführung des Verfahrens. In Figur 4 a) ist die Aufsicht und in Figur 4 b) der Schnitt entsprechend der Aufsicht geführt.

In der Figur 4 c) ist ein Ausschnitt aus der Bodenplatte 46 der Figur 4 b) mit entsprechenden Maßangaben in mm gezeigt, sowie in der Figur 4 d) ein kartesisches Koordinatensystem, das insbesondere für die Figuren 4 b) und c) anzuwenden ist und anzeigt, wie die Bewegung einer Transferschicht entlang der Z-Ebene der Kammer 40 erfolgt.

Die Kammer 40 besteht aus dem Hauptkörper 41, welcher während des erfindungsgemäßen Transfers mit deionisiertem Wasser 47 gefüllt wird, einer Vakuumansaugvorrichtung 42, 43 als Substrathalter für den Wafer, einem Eingangsventil 43 für die Vakuumversorgung, sechs Alignmentsäulen als Fixierstifte 44 und dem Einlass- und Ablassventil 45 am Boden des Körpers. Von den 6 Säulen 44 sind auf Grund des Schnitts nur 4 im unteren Teil der Figur erkennbar. In der Figur 4 a) ist nur einer der kreisförmig um den Substrathalter im Zentrum herum angeordneten Fixierstifte mit Bezugszeichen gekennzeichnet.

Der Wafer gemäß der Figur 2b, auf welchem die Platzhalter vorbereitet sind, wird auf dem Substrathalter 42, das heißt der Vakuumansaugvorrichtung, platziert. Daraufhin wird die Transferschicht mit ihren 6 Ausnehmungen 32 in den Ausstülpungen 35 über die sechs Alignmentsäulen als Fixierstifte 44 geführt und in X-Y-Ebene fixiert. Da der Durchmesser der Fixierstifte 44 jeweils 5 mm beträgt, ist bei einem Durchmesser von 5,25 mm der Löcher 32 in der Transferschicht gewährleistet, dass die Transferschicht noch in Z-Richtung der Kammer beweglich bleibt, nicht jedoch in der X-Y-Ebene der Transferschicht. Die Rotation der Transferschicht ist also ausgeschlossen.

Nachdem die Transferschicht mit ihren durch die Linien L_{w} und Lₛ aufgespannten schachbrettartigen Muster auf den 52 Chips grob ausgerichtet und in X-Y-Richtung fixiert wurde, erfolgt die Ausrichtung des Substrats durch Drehen des Substrats bis die Außenkanten jedes Chips C exakt unter seinen Linien L_{w} und Lₛ der Transferschicht ausgerichtet sind. Dadurch wird vorteilhaft gewährleistet, dass die Öffnungen 32 in der Transferschicht exakt mittig über den Platzhaltern auf den Chips zu liegen kommen. Danach wird das Vakuum angeschaltet und das Substrat fixiert.

Die Fixierstifte 44 bzw. Allignmentsäulen können wie in der Figur gezeigt in der Bodenplatte 46 verankert z. B. geschraubt sein. Ohne Einschränkung der Erfindung könnten sie aber auch auf dem Substrathalter 42 angeordnet sein. Es versteht sich also, dass die in der Figur 4 angegebenen Substrathalter, Fixierstifte und deren Anordnung zueinander in der Kammer lediglich beispielhaft angegeben sind.

Die Transferschicht ist mit einem maßstabsgetreuen Platzhalter-Muster und den Öffnungen 33 mit je 3 mm im Durchmesser für das Graphen vorbereitet und wird manuell so auf dem Substratwafer abgeglichen, dass die Öffnungen 33 exakt über den Platzhaltern 21 des Substrats liegen, an welchen das Graphen auf dem Wafer 20 platziert werden soll. Je besser diese Ausrichtung gemäß Schritt c) und d) des Verfahrens geschieht, desto besser und reproduzierbarer ist das Resultat des Transfers.

Sobald das deioinisierte Wasser 47 über das Einlassventil 45 eingelassen worden ist, beginnt die Transferschicht (nicht dargestellt) auf dem Wasser zu schwimmen und wird in Z-Richtung der Kammer wie in Figur 4 gezeigt, angehoben ohne rotieren zu können.

Das zu transferierende Graphen wurde auf einer 25µm dicken Kupferfolie bei 1000 °C für 30 Minuten CVD-gewachsen. Es wurden dabei 200 sccm Argon, 50 sccm Wasserstoff und 0,5 sccm CH₄ bei einem Druck von 12000 Pa als Wachstumsgase verwendet. Das Ramanspektrum zeigt eine Monolage CVD Graphen. Vor dem Wachstum wurden die Kupferfolien gründlich mit HCl, gefolgt von Aceton und Isopropanol, gereinigt.

PMMA (AR-P 669.04) wurde mittels Rotationsbeschichtung mit 1000rpm für 30s auf die Kupferfolie mit dem Graphen aufgetragen. Das PMMA wurde bei 150 °C für 5 Minuten erhitzt, um das Lösungsmittel zu entfernen. Die resultierende Schichtdicke des Polymers liegt zwischen 400nm und 500nm. Daraufhin wurde die Rückseite der Folie einem Sauerstoffplasma (50W, 5min, 200 sccm O₂) ausgesetzt, um die auf der Rückseite der Folie befindlichen Graphenspuren zu beseitigen.

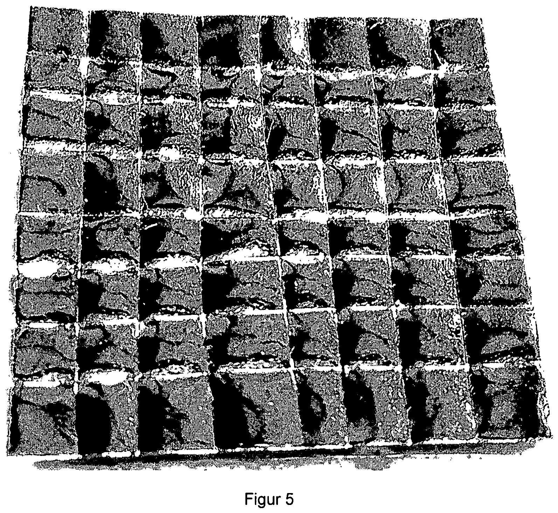

Figur 5 zeigt eine solche Folie aus drei übereinander liegenden Schichten. Eine untere Schicht besteht aus Kupfer. Hierauf angeordnet ist CVD-gewachsenes Graphen. Hierauf angeordnet ist PMMA. Die Folie kann mit einem Skalpell angeritzt werden, da dieses über eine sehr feine Spitze verfügt. Diese vorbereitete Folie wird in die Kupferätzlösung gegeben. Das PMMA dient dazu die Graphen-Stücke nach dem Ätzen des Kupfers dennoch aufnehmen zu können.

Vor dem Nassätzen des Kupfers wurde die PMMA/Graphen/Kupferfolie mechanisch mit einem Skalpell angeschnitten. Diese Schnitte wurden gesetzt um durch die PMMA/Graphen-Schicht zu schneiden, ohne dabei die darunterliegende Kupferfolie zu beschädigen. Nachdem die Kupferfolie in einer 100mM Ammoniumpersulfat-Lösung über Nacht geätzt wurde, werden viele kleine PMMA/Graphen-Stücke erhalten, welche auf der Oberfläche der Lösung treiben. Die Schnitte mit dem Skalpell erleichtern die Fabrikation von solchen klein-dimensionierten Stücken. Nach dem Kupferätzen wurden die Stücke in einer Spülkaskade mit de-ionisiertem Wasser gereinigt und mit der beschriebenen Methode transferiert.

Die so vorbereiteten PMMA/Graphen Stücke weisen eine Größe von etwa 2 mal 2 mm² auf und passen somit gerade in die Öffnungen 33 der Transferschicht 31. Die Graphen-Stücke werden mit dem Graphen nach unten sodann in jede der Öffnungen 33 der Transferschicht 31 transferiert und schwimmen in den Öffnungen 33 auf der Wasseroberfläche 47, gemäß der Schritte e)-f) des Verfahrens.

Durch das Öffnen des Ablassventils 45 in der Kammer wird der Wasserspiegel langsam gesenkt, bis die Transferschicht wieder auf dem Wafer aufliegt. Durch den genauen Abgleich der Transferschicht 31 mit dem Wafer werden die Graphen-Stücke genau an den gewünschten Stellen am Wafer platziert, das heißt auf den Platzhaltern des Substrats.

Nachdem das Wasser abgelassen wurde, wird die Transferschicht mit den PMMA/Graphen Stücken über Nacht getrocknet. Zuletzt wird die Transferschicht vom Wafer abgenommen und der Wafer mit den PMMA/Graphen Stücken wird wie in der Literatur bekannt nachbehandelt, wie beispielweise in Liang, X., Sperling, B. a, Calizo, I., Cheng, G., Hacker, C. A., Zhang, Q., Richter, C. a. (2011). Toward clean and crackless transfer of graphene. ACS Nano, 5(11), 9144-53) angegeben.

Nachdem die Stücke transferiert und getrocknet sind, wird der Wafer bei 160 °C für 15 Minuten erhitzt, um die Adhäsion zu verbessern und das PMMA wieder aufzuschmelzen. Zuletzt wird der Wafer für mindestens eine Stunde in Aceton getaucht um das PMMA zu entfernen und dann bei 350 °C in einer sauerstofffreien Umgebung ausgeheizt.

Figur 6a zeigt schematisch einen Wafer nach Figur 2b mit insgesamt 52 Platzhaltern 21 auf 52 Chips, dargestellt durch die schwarzen kleinen Punkte.

Jeder Platzhalter umfasst somit eine Fläche 21 im Chip, die etwa der Fläche des Graphen-Stückes entspricht. Jeder Wafer weist insgesamt 52 Chips mit Platzhaltern auf (Figur 6b), auf welche das Graphen transferiert werden soll. Dem entsprechend werden 52 Stücke Graphen präzise auf diese gewünschten Stellen in der Mitte der Chips transferiert.

Jeder der 52 Chips C in der Figur 6b) hat die Dimensionen von etwa 11 mal 11 mm². Allerdings ist die Fläche in der Mitte der Chips C und damit der eigentliche Platzhalter, für welche das Graphen vorgesehen ist, nur etwa 2 mal 2 mm² groß (Figur 6d)). Diese Fläche wird durch eine Vielzahl an Metallisierungen 61 aufgespannt, von denen zwei in der Figur 6e) gezeigt werden und die als helle Linien 61 erscheinen. Der Platzhalter gemäß der Figur 6d) wird vollständig mit Graphen bedeckt und im Weiteren z. B. durch Einsatz weiterer Masken und Ätzen prozessiert, so dass die zwischen den Metallisierungen 61 angegebene Fläche durch Graphen 62 überbrückt wird. Die beiden Metallisierungen nach Figur 6e) stellen Source und Drain und das Graphen 62 einen Teil des Gate des G-FET dar, die knochenförmige Vertiefung senkrecht zwischen den Metallisierungen stellt ein Reservoir für einen Elektrolyt dar. Eine Vielzahl, hier insgesamt 32 derartiger FETs ist auf einem Platzhalter angegeben und wird entsprechend mit einem weiter zu prozessierenden Stück Graphen bedeckt, siehe Figur 6d).

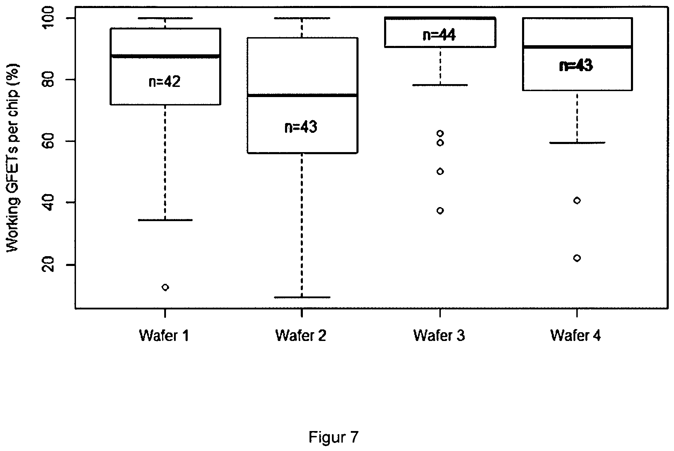

Der beschriebene Transfer wurde für vier Silizium Wafer durchgeführt. Bilder, welche mit Hilfe eines optischen Mikroskop angefertigt worden sind, wurden für jeden Chip eines jeden Wafers für die Transferausbeute analysiert, welche das Verhältnis zwischen funktionierenden Bauelementen zur Gesamtanzahl an Bauelementen, welche Graphen-basierte Feldeffekttransistoren sind, darstellt. Die funktionierenden Bauelemente wurden durch den Abgleich der Bilder mit dem Maskenmuster bestimmt, wobei der Maßstab berücksichtigt wurde. Die sich daraus ergebende Statistik dieser vier Wafer ist in der Figur 7 dargestellt. Der Mittelwert der Transferausbeute liegt bei etwa 80%.

Möglichkeiten der Abwandlung für das Ausführungsbeispiel sowie generell für das Verfahren sind gegeben:
Für die Kupferätzlösung sind alle Lösungen, welche Kupfer ätzen geeignet, z. B. Fe(NO₃)₃, FeCl₃ oder (NH₄)₂S₂O₈.

Die Lösungen greifen dabei allerdings nicht das Graphen und/oder das PMMA an. Es wäre vorstellbar, das Kupfer mittels Aqua Regina oder einer Salzsäurelösung zu ätzen. Diese würde allerdings auch das Graphen und das PMMA angreifen. Dementsprechend ist die Anforderung an die Ätzlösung, welche von den 3 gelisteten Beispielen gewährt ist, das Kupfer aufzulösen und dabei das Graphen und PMMA nicht oder so gering wie möglich zu beeinflussen.

Als Polymerfilme auf dem Graphen kommen PDMS (Polydimethylsiloxan), PMMA (Polymethylmethacrylat), PC (Poly(bisphenol A Carbonat)), Polylactide (PLA), Polyphthalamid (PPA), und so weiter in Frage, wobei auch deren Mischungen und Mehrfachlagen möglich sind.

Als Material für die Transferschicht kann jeder Polymer-Film verwendet werden, welcher vorzugsweise hydrophob und/oder transparent ist. Beispiele sind Kapton, PET, Polyester, Polyethylen, Polypropylen, Polyvinylchlorid, Polystyren, Polytetrafluoroethylen, Polymethylmethacrylat.

Anstatt Graphen auf Kupfer erlaubt die CVD Technologie auch das Wachstum auf anderen Metallfolien. Dazu gehören Nickel, Iridium, Ruthenium oder Kupfer-Nickel-Legierungen. Jede dieser bewachsenen Metallfolien kann als Graphenquelle für den Transferprozess genutzt werden, sofern man die Ätzlösung dem entsprechend anpasst.

Sonderbehandlungen der Siliziumoberfläche sind möglich, um für eine bessere Haftung des Graphens an der Oberfläche zu sorgen. Beispielsweise steigert die Verwendung von APTES Molekülen die Hydrophilität der Oberfläche und damit die Adhäsion und der Prozess wird vereinfacht.

Die Transferschicht kann auch intransparent sein, sofern eine andere Art des Abgleiches der Öffnungen über den Platzhalter des Substrats erfolgt. Dies kann durch den genauen Abgleich zwischen den Substrat und den Alignmentsäulen bzw. Fixierstiften 44 erfolgen. Dadurch wäre eine transparente Transferschicht als Vermittlerfilm nicht mehr notwendig, sondern es wäre auch eine intransparente Transferschicht ausreichend.

Für den Fall das keine Silizium basierten Wafer als Substrate verwendet werden, kann der Transfer noch weiter vereinfacht werden. Da das Kupfer eine Quelle für Verunreinigungen in der Siliziumtechnologie darstellt, ist es nicht wünschenswert einen Si-Wafer in eine Kupferätzlösung zu legen. Wird hingegen Aluminiumoxid (Saphir) oder ein flexibles Substrat verwendet, so kann die Prozedur wie folgend vereinfacht werden:
Das Zielsubstrat wird in die Mitte der Vakuumansaugvorrichtung als Substrathalter 42 für das Substrat gelegt. Die Transferschicht wird durch die Fixierstifte als Alignmentsäulen mit dem Zielsubstrat abgeglichen und die Öffnungen über den Platzhaltern angeordnet.

Das Vakuum wird angelegt, um das Substrat auf seiner Position am Substrathalter zu fixieren.

Die Hauptkammer wird mit der Kupferätzlösung über die Oberfläche des Substrats gefüllt, wodurch die Transferschicht auf der Kupferätzlösungsoberfläche über dem Substrat schwimmt.

Die N_g PMMA/Graphenstücke werden einzeln, noch auf der Kupferfolie befindlich, in die Öffnungen des Vermittlerfilms transferiert.

Es wird solange gewartet, bis die Kupferfolie vollständig aufgelöst ist.

Die Ätzlösung wird durch Öffnen des Ablassventils langsam abgelassen und durch deionisiertes Wasser zum Reinigen ersetzt. Es erfolgen mehrere Wasser Ablass- und Auffüllschritte, um ein saubereres Interface zwischen Graphen und Wunschsubstrat zu schaffen.

Das Wasser wird abschließend komplett abgelassen und das Substrat mit den darauf befindlichen Graphen-Stücken über Nacht getrocknet.

Es versteht sich, dass weitere Abwandlungen je nach Substrat und zu transferierenden zweidimensionalen Material vorgesehen werden können.

## Patentansprüche

1. Verfahren zum Transfer von Graphen-Stücken auf ein Substrat, **gekennzeichnet durch** die Schritte:
a) Es wird ein Substrat (20) mit einer Mehrzahl an Platzhaltern (21) für die Graphen-Stücke ausgewählt;
b) Das Substrat (20) wird auf einem Substrathalter (42) in einer Kammer (40) angeordnet und ausgerichtet;
c) Es wird eine Transferschicht (31) mit Öffnungen (33) als Platzhalter für die Graphen-Stücke ausgewählt;
d) Die Transferschicht (31) wird auf dem Substrathalter (42) über dem Substrat (20) angeordnet und ausgerichtet, so dass die Öffnungen (33) in der Transferschicht über den Platzhaltern (21) auf dem Substrat ausgerichtet werden;
e) Es wird eine Flüssigkeit (47) in die Kammer (40) bis oberhalb der Transferschicht eingefüllt, und die Transferschicht auf der Flüssigkeitssäule (47) angehoben;
f) Es werden Graphen-Stücke auf den Flüssigkeitsfilm (47) in die Öffnungen (33) der Transferschicht eingebracht;
g) Der Abstand zwischen dem Substrat und den Graphen-Stücken in den Öffnungen (33) wird verringert, bis die Graphen-Stücke (62) auf den Platzhaltern (21) des Substrats angeordnet werden.

2. Verfahren nach Anspruch 1,
**dadurch gekennzeichnet, dass**
die Platzhalter (21) des Substrats mit den Öffnungen (33) der Transferschicht für die Graphen-Stücke mittels mindestens einem Fixierstift (44) zueinander ausgerichtet werden, insbesondere durch mindestens 2 bis 6 Fixierstifte (44).

3. Verfahren nach einem der vorhergehenden Ansprüche,
**dadurch gekennzeichnet, dass**
die Transferschicht während der Schritte d) bis g) in ihrer X-Y-Ebene fixiert ist.

4. Verfahren nach einem der vorhergehenden Ansprüche,
**dadurch gekennzeichnet, dass**
die Transferschicht Ausnehmungen (32) am Rand der Transferschicht umfasst, die über die Fixierstifte (44) geführt werden.

5. Verfahren nach einem der vorhergehenden Ansprüche,
**dadurch gekennzeichnet, dass**
in Schritt g) die Flüssigkeit aus der Kammer entnommen wird, so dass die Transferschicht auf der Flüssigkeitssäule (47) abgesenkt wird, und/oder das Substrat angehoben wird, so dass die Graphen-Stücke in den Öffnungen (33) der Transferschicht auf die Platzhalter (21) des Substrats transferiert werden.

6. Verfahren nach einem der vorhergehenden Ansprüche,
**dadurch gekennzeichnet, dass**
Restflüssigkeit entfernt wird.

7. Substrat, hergestellt durch ein Verfahren nach einem der vorherigen Ansprüche, mit einer Mehrzahl an Graphen-Stücken auf einem Substrat mit einer Mehrzahl an Platzhaltern für die Graphen-Stücke zur Herstellung Graphen basierender Bauelemente.

8. Vorrichtung zur Durchführung des Verfahrens nach einem der vorherigen Ansprüche, umfassend
- eine mit Flüssigkeit (47) befüllbare Kammer (40) mit einem Substrathalter (42) für ein Substrat,
- Mittel (42, 43, 44) zur Ausrichtung des Substrats und einer darauf angeordneten Transferschicht (31, Lₛ, L_{w}) auf dem Substrathalter (42), wobei die Mittel (44) die Transferschicht in ihrer X-Y-Ebene fixieren und in der Z-Ebene, das heißt vertikal zur Substrat-Oberfläche, die Bewegung der Transferschicht ermöglichen.

9. Vorrichtung nach vorherigem Anspruch,
**gekennzeichnet durch**
Einlassventil und/oder Auslassventil (45) für die Flüssigkeit sowie mindestens einem Fixierstift (44), vorzugsweise bis zu 6 Fixierstiften (44).

10. Vorrichtung nach einem der vorhergehenden zwei Ansprüche,
**gekennzeichnet durch**
einen Hebemechanismus zur Anhebung des Substrathalters (42).

## Claims

1. A method for transferring graphene pieces to a substrate, **characterized by** the following steps:
a) A substrate (20) with a plurality of placeholders (21) for the graphene pieces is selected;
b) The substrate (20) is arranged and aligned on a substrate holder (42) in a chamber (40);
c) A transfer layer (31) with openings (33) is selected as placeholder for the graphene pieces;
d) The transfer layer (31) is arranged and aligned on the substrate holder (42) above the substrate (20) so that the openings (33) in the transfer layer are aligned above the placeholders (21) on the substrate;
e) A liquid (47) is filled into the chamber (40) up to above the transfer layer, and the transfer layer is raised on the liquid column (47);
f) Graphene pieces on the liquid film (47) are inserted into the openings (33) of the transfer layer;
g) The distance between the substrate and the graphene pieces in the openings (33) is reduced until the graphene pieces (62) are arranged on the placeholders (21) of the substrate.

2. A method according to claim 1,
**characterized in that**
the placeholders (21) of the substrate with the openings (33) of the transfer layer for the graphene pieces are aligned relative to each other by means of at least one fixing pin (44), in particular by at least 2 to 6 fixing pins (44).

3. A method according to any one of the preceding claims,
**characterized in that**
the transfer layer is fixed in its X-Y-plane during the steps d) to g).

4. A method according to any one of the preceding claims,
**characterized in that** the transfer layer comprises recesses (32) at the edge of the transfer layer which are guided over the fixing pins (44).

5. A method according to any one of the preceding claims,
**characterized in that**
the liquid is taken out from the chamber in step g) so that the the transfer layer is lowered onto the liquid column (47), and/or the substrate is raised so that the graphene pieces in the openings (33) of the transfer layer are transferred to the placeholders (21) of the substrate.

6. A method according to any one of the preceding claims,
**characterized in that**
residual liquid is removed.

7. A substrate, produced by a method according to any one of the preceding claims, with a plurality of graphene pieces on a substrate with a plurality of placeholders for the graphene pieces for the production of components based on graphene.

8. A device for performing the method according to any one of the preceding claims, comprising
- a chamber (40) which can be filled with liquid (47) and has a substrate holder (42) for a substrate,
- means (42, 43, 44) for aligning the substrate and a transfer layer (31, Lₛ, L_{w}), which is arranged thereon, on the substrate holder (42), wherein the means (44) fix the transfer layer in its X-Y-plane and enable the transfer layer to move in the Z-plane, i.e. vertically to the substrate surface.

9. A device according to preceding claim,
**characterized by**
inlet valve and/or outlet valve (45) for the liquid as well as at least one fixing pin (44), preferably up to 6 fixing pins (44).

10. A device according to any one of the preceding two claims,
**characterized by**
a lifting mechanism for lifting the substrate holder (42).

## Revendications

1. Procédé de transfert de pièces de graphène à un substrat, **caractérisé par** les stades :
a) on choisit un substrat (20) ayant une pluralité d'emplacements (21) pour les pièces de graphène ;
b) on met et on oriente le substrat sur un support (42) de substrat dans une chambre (40) ;
c) on choisit une couche (31) de transfert ayant des ouvertures (33) comme emplacements pour les pièces de graphène ;
d) on met, on oriente la couche (31) de transfert sur le support (42) de substrat au-dessus du substrat (20), de manière à orienter les ouvertures (33) de la couche de transfert au-dessus des emplacements (21) sur le substrat ;
e) on remplit la chambre (40) d'un liquide (47) jusqu'au-dessus de la couche de transfert et on soulève la couche de transfert sur la colonne (47) de liquide ;
f) on introduit des pièces de graphène sur la pellicule (47) de liquide dans les ouvertures (33) de la couche de transfert ;
g) on diminue la distance entre le substrat et les pièces de graphène dans les ouvertures (33) jusqu'à ce que les pièces (62) de graphène soient disposées aux emplacements (21) du substrat.

2. Procédé suivant la revendication 1,
**caractérisé en ce que**
l'on oriente, les uns par rapport aux autres, les emplacements (21) du substrat avec les ouvertures (33) de la couche de transfert pour les pièces de graphène au moyen d'au moins une tige (44) d'immobilisation, notamment par au moins 2 à 6 tiges (44) d'immobilisation.

3. Procédé suivant l'une des revendications précédentes,
**caractérisé en ce que**
la couche de transfert est immobilisée dans son plan X-Y pendant les stades d) à g).

4. Procédé suivant l'une des revendications précédentes,
**caractérisé en ce que**
la couche de transfert comprend des évidements (32) a bord de la couche de transfert, dans lesquels passent les tiges (44) d'immobilisation.

5. Procédé suivant l'une des revendications précédentes,
**caractérisé en ce que**,
au stade g), on retire le liquide de la chambre de manière à abaisser la couche de transfert sur la colonne (47) de liquide et/ou **en ce que** l'on soulève le substrat de manière à transférer aux emplacements (21) du substrat les pièces de graphène dans les ouvertures (33) de la couche de transfert.

6. Procédé suivant l'une des revendications précédentes,
**caractérisé en ce que**
l'on enlève le liquide restant.

7. Substrat fabriqué par un procédé suivant l'une des revendications précédentes, comprenant une pluralité de pièces de graphène sur un substrat ayant une pluralité d'emplacements pour les pièces de graphène pour la fabrication de composants à base de graphène.

8. Installation pour effectuer le procédé suivant l'une des revendications précédentes, comprenant
- une chambre (40), qui peut être remplie de liquide (47) et qui a un support (42) de substrat pour un substrat,
- des moyens (42, 43, 44) d'orientation, sur le support (42) de substrat, du substrat et d'une couche (31, Lₛ, L_{w}) de transfert disposée dessus, les moyens (44) immobilisant la couche de transfert dans son plan X-Y et permettant le déplacement de la couche de transfert dans le plans Z, c'est-à-dire verticalement par rapport à la surface du substrat.

9. Installation suivant la revendication précédente,
**caractérisée par**
un robinet d'entrée et/ou un robinet (45) de sortie du liquide, ainsi qu'au moins une tige (44) d'immobilisation, de préférence jusqu'à 6 tiges (44) d'immobilisation.

10. Installation suivant l'une des deux revendications précédentes,
**caractérisée par**
un mécanisme de levage pour lever le support (42) de substrat.
